# FASCICULE DE BREVET EUROPEEN

(11) **EP 1 964 176 B1**
(45) Date de publication et mention de la délivrance du brevet: **03.01.2018**
(21) Numéro de dépôt: 06807744.5
(22) Date de dépôt: 06.11.2006
(51) Int. Cl.: H01L 21/768, H01L 23/48, H01L 31/0224, H01L 27/146

(54) **CAPTEUR D'IMAGE AMINCI A PLOTS DE CONTACT ISOLES PAR TRANCHEE**
VERDÜNNTER BILDSENSOR MIT GRABENISOLIERTEN KONTAKTSTELLEN
THINNED IMAGE SENSOR HAVING TRENCH-ISOLATED CONTACT PADS

(30) Priorité: 23.12.2005 FR 0513221
(43) Date de publication de la demande: 03.09.2008
(73) Titulaire: Teledyne E2V Semiconductors SAS, 38120 Sain-Egrève (FR)
(72) Inventeur: BLANCHARD, Pierre, 38130 Echirolles (FR)
(74) Mandataire: Desvignes, Agnès
(86) Numéro de dépôt international: PCT/EP2006/068107
(87) Numéro de publication internationale: WO 2007/071491

(56) Documents cités:
- JP-A- 2005 167 090
- JP-A- 2005 285 814
- US-A1- 2005 104 148

## Description

L'invention concerne la fabrication des capteurs d'image à substrat aminci, et notamment les capteurs d'image en couleurs.

Les capteurs d'image à substrat aminci ont été conçus pour améliorer les performances colorimétriques des capteurs en permettant l'éclairement du capteur par la face arrière à travers une couche de silicium très mince ; cette disposition permet d'éviter la dispersion des photons et des électrons photogénérés dans le substrat et donc d'éviter une diaphotie qui nuirait beaucoup à la colorimétrie puisque les pixels d'image voisins correspondent à des couleurs différentes.

La fabrication d'un capteur d'image sur substrat aminci comprend généralement les étapes suivantes : on part d'un substrat de silicium (monocristallin massif ou substrat de silicium sur isolant SOI par exemple), d'une épaisseur de quelques centaines de micromètres, permettant la manipulation industrielle de tranches de dix ou vingt centimètres de diamètre, ce substrat étant revêtu sur une face avant d'une couche épitaxiale de silicium monocristallin qui contiendra les circuits actifs du capteur. On réalise dans cette couche épitaxiale, à partir de la face avant, la circuiterie électronique nécessaire aux différentes fonctions du capteur (prise d'image, traitement de signaux). Puis on colle le substrat, par sa face avant qui porte cette circuiterie, sur un substrat de report d'une épaisseur suffisante pour la manipulation industrielle, et on amincit le substrat de silicium de départ jusqu'à une épaisseur de quelques micromètres. L'épaisseur très fine de silicium qui en résulte ne permettrait pas la manipulation industrielle de la tranche, et c'est la raison de la présence du substrat de report collé. L'épaisseur très fine, dans le cas d'un capteur d'image en couleurs, sert à améliorer considérablement les qualités colorimétriques du capteur, l'éclairement du capteur se faisant par la face arrière, à travers une couche de filtres colorés déposés sur cette face arrière et à travers la couche très fine de silicium épitaxial.

Un des problèmes qu'on rencontre dans cette technologie est celui de la réalisation des plots de contact qui servent à la connexion électrique du capteur avec l'extérieur.

Une solution déjà proposée consiste à prévoir des métallisations de contact lors des étapes de traitement effectuées sur la face avant, et de creuser ensuite dans le silicium aminci, à partir de la face arrière, des ouvertures larges et profondes qui mettent à nu ces métallisations. Un fil de soudure peut alors être soudé sur les métallisations à l'intérieur de ces ouvertures. Mais cela oblige parfois à prévoir des ouvertures larges (120 à 180 micromètres de largeur typiquement). La largeur totale des plots ainsi constitués est alors beaucoup plus importante que la largeur classiquement prévue pour des plots de connexion de circuits électroniques CMOS classiques (typiquement des plots de 60 micromètres de large suffisent).

De plus, les ouvertures doivent être faites avant le dépôt des filtres de couleur sur le capteur ; or la présence de ces ouvertures perturbe l'homogénéité de répartition des couches de filtrage ; en outre le dépôt de ces couches de filtrage va laisser dans les ouvertures des résidus qu'on ne sait pas bien enlever alors qu'il est indispensable de les enlever pour assurer la soudure des fils de connexion.

Une autre solution a pu être envisagée, consistant à former des ouvertures lors du traitement de face avant c'est-à-dire avant le report sur un substrat de report ; les ouvertures sont faites à l'endroit des plots de connexion, sur toute la profondeur qui subsistera après amincissement, et le fond de ces ouvertures est métallisé. Après report et amincissement, le fond métallisé est accessible sur la face arrière amincie et constitue le plot de connexion, cette fois dans le même plan que la face de sortie et non au fond d'une ouverture. Mais un tel procédé oblige à des étapes qui ne sont pas classiques dans un procédé industriel CMOS typique de sorte que les tranches de silicium portant les capteurs ne pourraient pas facilement être insérées dans un processus de production industrielle où à la fois des capteurs de ce genre et des circuits plus classiques (substrats non amincis) doivent être réalisés.

Le document JP 2005 285814 montre (figures 3-6 et 17) un procédé pour réaliser un plot de connexion d'un capteur d'image à substrat de silicium aminci, qui utilise une tranchée pour prévenir la migration métallique lors de la gravure d'une ouverture à travers le substrat aminci.

Pour éviter les inconvénients des procédés connus, la présente invention propose un nouveau procédé de fabrication d'un capteur d'image à substrat de silicium aminci, selon la revendication 1. Le procédé comprend des étapes de fabrication faites à partir de la face avant d'un substrat de silicium puis le report de la face avant sur un substrat de report puis l'amincissement du substrat de silicium jusqu'à une épaisseur de quelques micromètres (typiquement entre 3 et 20 micromètres), et enfin des étapes de fabrication effectuées sur la face arrière du substrat de silicium aminci. qui comprennent successivement:
- la gravure d'au moins une ouverture de contact ponctuelle à travers le substrat aminci, sur une surface réservée à l'établissement d'un plot de connexion du capteur avec l'extérieur, l'ouverture mettant à nu ponctuellement une première couche conductrice formée pendant les étapes de fabrication effectuées à partir de la face avant ;
- le dépôt d'une deuxième couche conductrice sur la face arrière, en contact avec le silicium dans l'ouverture, la deuxième couche venant en contact avec la première couche ;
- la gravure de la deuxième couche pour délimiter un plot de connexion ;
- l'ouverture d'une tranchée périphérique à travers toute l'épaisseur du substrat de silicium aminci jusqu'à une couche isolante située sous ce substrat, cette tranchée entourant complètement le plot de connexion et le fond de la tranchée étant entièrement constitué par la couche isolante, constituant ainsi un îlot de silicium aminci recouvert par le plot de connexion et isolé par la tranchée du reste du silicium aminci.

Grâce à la tranchée périphérique, il n'est pas nécessaire d'isoler par une couche isolante la deuxième couche conductrice du silicium et c'est pourquoi la deuxième couche conductrice est déposée directement en contact avec le silicium.

Un fil peut alors être soudé sur une partie du plot de connexion. La partie du plot de connexion sur laquelle est soudé le fil est de préférence dépourvue d'ouvertures.

Une couche de planarisation isolante est de préférence déposée sur la face arrière après ouverture de la tranchée, et une ouverture est gravée dans cette couche pour dégager une portion de surface du plot de connexion, sur laquelle on peut venir souder un fil.

De préférence, on prévoit plusieurs ouvertures de contact ponctuelles à travers le substrat aminci pour établir une série de contacts ponctuels avec la première couche conductrice sous-jacente.

D'autres caractéristiques et avantages de l'invention apparaîtront à la lecture de la description détaillée qui suit et qui est faite en référence aux dessins annexés dans lesquels
- les figures 1 à 8 illustrent les étapes successives principales du procédé selon l'invention ;
- la figure 9 représente en vue de dessus la configuration générale du plot de connexion avec ses multiples ouvertures de contact.

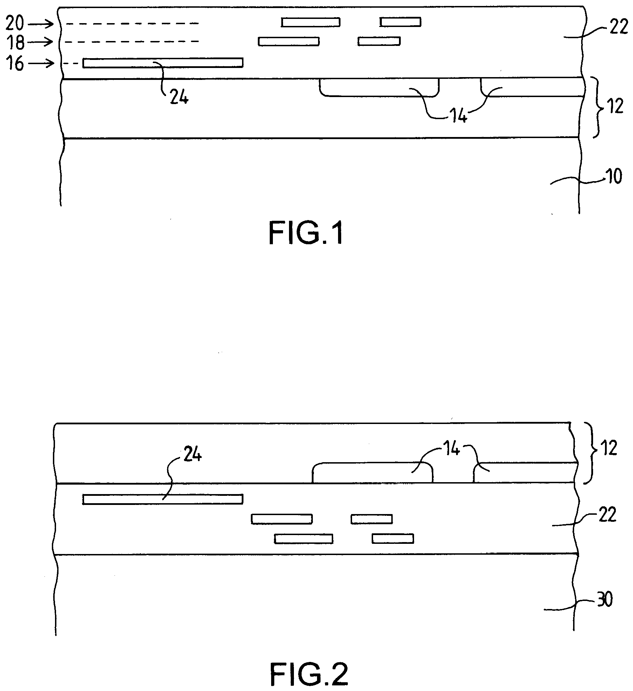

Sur la figure 1 on a représenté un substrat de silicium 10 comportant une couche épitaxiale superficielle 12 dans laquelle seront réalisés les éléments actifs du circuit intégré, et notamment les éléments photosensibles du capteur d'image. Les circuits électroniques du capteur, comprenant par exemple une matrice active photosensible et des circuits périphériques, sont fabriqués par des opérations classiques de dépôts, gravures, dopages, de différentes couches isolantes, conductrices ou semiconductrices et toutes ces opérations sont faites à partir de la face avant du substrat, à savoir la face sur laquelle se trouve la couche épitaxiale. Le substrat 10 peut être un substrat de silicium monocristallin massif ou un substrat de type SOI (de l'anglais "silicon on insulator", silicium sur isolant) comportant une couche épitaxiale séparée du substrat par une fine couche d'oxyde de silicium.

On a représenté schématiquement sur la face avant la couche épitaxiale 12 avec des zones semiconductrices dopées 14, et, au-dessus de la couche épitaxiale 12, plusieurs niveaux de couches conductrices 16, 18, 20 superposées, séparés les uns des autres par des couches isolantes. Les couches conductrices sont gravées selon des motifs désirés dictés par la fonctionnalité du circuit, et peuvent être reliées par endroit les unes aux autres par des vias conducteurs à travers les couches isolantes. Les couches isolantes sont désignées globalement par 22 sans qu'on les distingue les unes des autres bien qu'elles soient déposées et gravées successivement en alternant couches conductrices et couches isolantes.

Le capteur se présente donc globalement, à la fin des étapes de fabrication sur la face avant, comme un substrat de silicium 10 revêtu d'une couche épitaxiale 12 comportant notamment des motifs de dopages différents, cette couche épitaxiale étant elle-même revêtue d'une couche isolante 22 dans laquelle sont noyés plusieurs niveaux conducteurs gravés. La face supérieure de la couche 22 est plane, notamment du fait qu'une couche de planarisation isolante a pu être déposée en dernier sur le substrat.

Parmi les couches conductrices, on a prévu une couche 16 dans laquelle on forme des plages conductrices 24 dans des zones qui correspondent géographiquement à des plots destinés à la connexion du capteur avec l'extérieur. Les plots de connexion étant le plus souvent à la périphérie d'une puce, les plages conductrices 24 sont en principe situées à la périphérie de la puce. La plage conductrice 24, à l'endroit du plot, est séparée de la couche épitaxiale 12 par une petite épaisseur de couche isolante. La couche conductrice 16 peut être en aluminium. Les couches isolantes sont principalement en oxyde de silicium, mais il peut y avoir d'autres matériaux isolants dans la couche 22. La plage conductrice 24 peut être relativement étendue (plusieurs dizaines de micromètres de côté), continue ou en grille ajourée, ou bien elle peut être de petites dimensions (quelques micromètres) si les courants véhiculés par les plots sont faibles.

Le circuit intégré ayant ainsi subi les opérations de traitement nécessaires à partir de la face avant est maintenant collé, par cette face avant, sur la face avant d'un substrat de report 30. On notera que cette opération est faite au niveau des tranches (en anglais « wafer ») de silicium et non pas après découpe de la tranche en puces individuelles. Avant le collage, on procède aux opérations de planarisation nécessaires pour que la tranche et le substrat de report adhèrent parfaitement l'un à l'autre, tout spécialement si le collage est fait par adhésion moléculaire sans apport de matière adhésive.

Puis, après collage, on amincit le silicium du substrat 10 par sa face arrière, par des opérations d'usinage mécanique et chimique, de manière à ne laisser subsister qu'une très faible épaisseur de silicium ; pratiquement on ne laisse que la couche épitaxiale 12 (ou à peine plus que la couche épitaxiale), soit quelques micromètres. La figure 2 représente la mince couche de silicium 12 qui subsiste, retournée et collée par sa face avant (tournée vers le bas) sur la face avant (tournée vers le haut) du substrat de report 30.

Le substrat de report 30 assure maintenant la tenue mécanique de la tranche. On effectue alors à partir de la face arrière de la couche épitaxiale (en haut sur la figure 2), différentes opérations de traitement, et notamment les opérations nécessaires à la réalisation de plots de connexion pour la connexion du circuit avec l'extérieur.

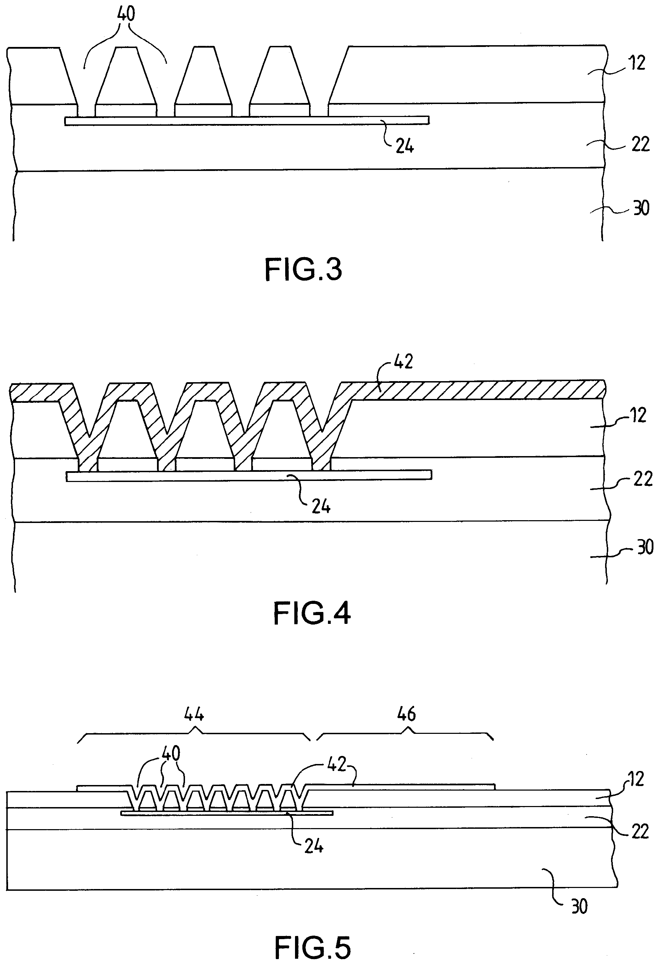

Pour cela, on ouvre dans toute l'épaisseur de la couche épitaxiale 12 une série d'ouvertures 40 distribuées au-dessus de chacune des plages conductrices 24 qui sont destinées à être reliées électriquement aux plots de connexion. Dans certains cas, on peut se contenter d'une seule ouverture 40 ; dans tous les cas les ouvertures sont localisées au-dessus de parties conductrices de la plage 24. La figure 3 représente une vue de la partie du circuit intégré qui comprend une plage 24 et les ouvertures 40 formées au-dessus de cette plage. Seul un petit nombre d'ouvertures ponctuelles est représenté pour simplifier la figure. Après avoir gravé ces ouvertures dans toute l'épaisseur de silicium de la couche 12, on complète les ouvertures en enlevant les portions de couche isolante 22 situées au fond des ouvertures, jusqu'à mettre à nu la plage conductrice 24.

On dépose alors une couche conductrice 42, par exemple de l'aluminium. Dans ce qui suit on appellera la couche 16 (celle qui contient la plage conductrice 24) première couche conductrice et la couche 42 deuxième couche conductrice, les deux couches conductrices participant à la formation d'un plot de connexion du circuit intégré avec l'extérieur. Le dépôt de la deuxième couche conductrice 42 peut être précédé d'une étape de dopage superficiel du silicium.

La deuxième couche conductrice 42 remplit les ouvertures et vient en contact par chacune de ces ouvertures avec la première couche conductrice constituant la plage 24 (figure 4).

Après ce dépôt, on grave la deuxième couche conductrice 42 pour délimiter un plot de connexion extérieure. La figure 5 représente une vue générale du plot de connexion, avec de préférence une partie 44 (à gauche sur la figure) percée d'ouvertures distribuées au-dessus de la plage 24 et une autre partie 46 non percée d'ouvertures (à droite) qui sera réservée à la soudure d'un fil de connexion. On notera que si les ouvertures individuelles sont suffisamment petites, on peut aussi envisager d'avoir un plot de connexion dont toute la surface comporte une distribution régulière d'ouvertures, le fil étant alors soudé sur une surface métallique qui comporte le relief engendré par les ouvertures 40 ; la plage 24 occuperait alors la majeure partie ou la totalité de la surface située sous le plot de connexion.

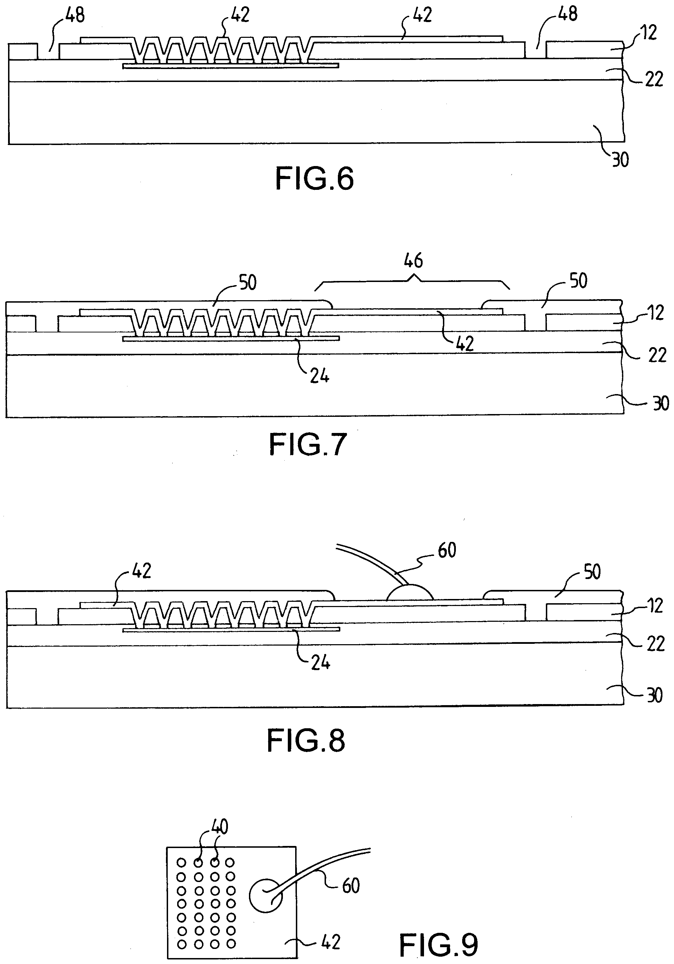

La figure 6 représente l'étape suivante : on grave une tranchée périphérique 48 entourant complètement le plot de connexion, sur toute la profondeur de la couche épitaxiale, jusqu'à la couche isolante 22. Cette tranchée s'arrête sur la couche isolante 22 et ne descend pas jusqu'à une portion de couche métallique, de sorte que le fond de la tranchée est entièrement constitué par une surface isolante.

L'étape suivante, figure 7, n'est pas obligatoire mais elle est préférable. Elle comprend le dépôt d'une couche de protection isolante 50 et l'ouverture de cette couche au-dessus du centre du plot de connexion conducteur (donc en principe dans la partie 46 du plot si on a prévu une partie non percée d'ouvertures réservée à la soudure d'un fil). La couche isolante 50 comble la tranchée périphérique 48.

Les étapes classiques de dépôt et photogravure des filtres colorés ne sont pas représentées.

Enfin, après découpe de la tranche en puces individuelles, l'étape finale de fabrication comprendra la soudure d'un fil de connexion 60 sur le métal 42 du plot de connexion là où il est dénudé (figure 8).

L'allure générale du plot de connexion avec ses multiples trous de contact avec la couche 24 sous-jacente et avec la partie dépourvue de trous est représentée en vue de dessus sur la figure 9. On prévoit de préférence plusieurs dizaines de trous de petites dimensions (quelques micromètres de diamètre ou de côté), mais comme on l'a dit précédemment un seul trou peut suffire dans certains cas.

On a ainsi réalisé un plot de connexion sans avoir eu besoin de déposer une couche isolante sur les flancs des ouvertures 40 avant de déposer le métal de connexion 42. Le métal 42 est en contact avec le silicium, mais le silicium est isolé par la tranchée du reste de la couche épitaxiale qui contient les circuits actifs ; ainsi, les potentiels appliqués à un plot soit par l'extérieur soit par l'intérieur du circuit intégré n'influencent pas le reste du circuit ou les autres plots.

Qu'il y ait ou non une couche de protection finale 50, l'étalement de résine ou de couches de filtrage n'est pas gêné par l'existence des plots de connexion. Ceux-ci sont en creux lorsqu'il y a une couche 50 mais la différence de niveau entre la surface du plot et la surface de la couche 50 est faible. S'il n'y a pas de couche 50, les ouvertures 40, qui sont d'ailleurs partiellement comblées par le métal, sont de petites dimensions (quelques micromètres de côté ou de diamètre) et ne gênent pas l'étalement. De plus, l'absence de décrochement entre la surface du plot de connexion et la surface environnante rend possible une limitation des dimensions du plot à environ 50 à 60 micromètres de côté, limitation qui n'était pas envisageable avec une surface métallique trop en profondeur par rapport à la surface supérieure de la puce de circuit-intégré.

Les ouvertures 40 sont de préférence formées par attaque chimique du silicium ; les ouvertures sont alors à flancs obliques, l'inclinaison correspondant aux plans de clivage naturel du silicium (55°). La tranchée 48 est de préférence gravée par attaque anisotrope verticale (gravure au plasma) et ses flancs latéraux sont verticaux. Sa largeur peut être de quelques micromètres (de 1 à 3 micromètres par exemple). La tranchée 48 n'est pas faite en même temps que les ouvertures 40 (bien que ce soit théoriquement possible), afin qu'elle ne soit pas remplie d'aluminium lors du dépôt de la couche 42, car il serait ensuite difficile d'éliminer l'aluminium du fond de la tranchée lors de la gravure qui délimite le plot de connexion.

## Revendications

1. Procédé de fabrication d'un capteur d'image à substrat de silicium aminci, comprenant des étapes de fabrication faites à partir de la face avant d'un substrat de silicium, ces étapes comprenant la formation d'éléments actifs et notamment les éléments photosensibles du capteur d'image, le dépôt d'au moins une couche isolante (22) et le dépôt d'une première couche conductrice (24), ladite couche isolante (22) revêtant la face avant du substrat silicium (12) et ladite première couche conductrice (24) étant noyée dans ladite couche isolante (22), puis le report de la face avant revêtue par la couche isolante (22) sur un substrat de report, puis l'amincissement du substrat de silicium par sa face arrière jusqu'à une épaisseur de 3 à 20 micromètres, et enfin des étapes de fabrication effectuées sur la face arrière du substrat de silicium aminci, qui comprennent successivement :
- la gravure d'au moins une ouverture de contact ponctuelle (40) à travers le substrat aminci (12), sur une surface réservée à l'établissement d'un plot de connexion du capteur avec l'extérieur, l'ouverture mettant à nu ponctuellement ladite première couche conductrice (24) formée pendant les étapes de fabrication effectuées à partir de la face avant ;
- le dépôt d'une deuxième couche conductrice (42) sur la face arrière, en contact avec le silicium du substrat dans l'ouverture (40) et en dehors de l'ouverture, la deuxième couche venant en contact avec la première couche (24) dans l'ouverture ;
- la gravure de la deuxième couche conductrice (42) pour délimiter un plot de connexion en contact avec le silicium en dehors de l'ouverture et en contact avec la première couche conductrice (24) dans l'ouverture ;
- l'ouverture d'une tranchée périphérique (48) à travers toute l'épaisseur du substrat de silicium aminci jusqu'à la couche isolante (22) située sous ce substrat aminci, cette tranchée entourant complètement le plot de connexion et le fond de la tranchée étant entièrement constitué par la couche isolante, constituant ainsi un îlot de silicium aminci recouvert par le plot de connexion et isolé par la tranchée du reste du substrat de silicium aminci qui contient les éléments actifs et notamment les éléments photosensibles.

2. Procédé selon la revendication 1, **caractérisé en ce qu'**un fil (60) est soudé sur une partie du plot de connexion.

3. Procédé selon la revendication 2, **caractérisé en ce que** la partie (46) du plot de connexion sur laquelle est soudé le fil est dépourvue d'ouvertures ponctuelles.

4. Procédé selon l'une des revendications 1 à 3, **caractérisé en ce qu'**une couche de protection isolante (50) est déposée sur la face arrière après ouverture de la tranchée, et une ouverture est gravée dans cette couche pour dégager une portion de surface du plot de connexion, sur laquelle on vient souder un fil.

5. Procédé selon l'une des revendications précédentes, **caractérisé en ce que** les ouvertures ponctuelles sont faites par gravure chimique.

6. Procédé selon l'une des revendications précédentes, **caractérisé en ce que** la tranchée est gravée par attaque anisotrope verticale.

7. Procédé selon l'une des revendications précédentes, **caractérisé en ce qu'**on grave une série d'ouvertures ponctuelles à travers le substrat aminci, ces ouvertures étant distribuées au-dessus d'une plage conductrice de la première couche conductrice (24), cette plage étant destinée à être reliée électriquement au plot de connexion.

## Patentansprüche

1. Verfahren zur Herstellung eines Bildsensor mit verdünntem Siliciumsubstrat, umfassend Herstellungsschritte beginnend auf der Vorderseite eines Siliciumsubstrats, diese Schritte umfassend die Bildung von aktiven Elementen und besonders lichtempfindlichen Elementen des Bildsensors, das Aufbringen von mindestens einer Isolierschicht (22) und das Aufbringen einer ersten Leitschicht (24), wobei die Isolierschicht (22) die Vorderseite des Siliciumsubstrat (12) überzieht und die erste Leitschicht (24) in die Isolierschicht (22) eingebettet ist, dann die Verlagerung der durch die Isolierschicht (22) überzogenen Vorderseite auf ein Verlagerungssubstrat, dann die Verdünnung des Siliciumsubstrats auf seiner Rückseite bis auf eine Stärke von 3 bis 20 Mikrometern, und schließlich die durchgeführten Herstellungsschritte auf der Rückseite des verdünnten Siliciumsubstrats, die nacheinander Folgendes umfassen:
- die Gravur von mindestens einer Punktkontaktöffnung (40) durch das verdünnte Substrat (12) auf einer reservierten Fläche für die Herstellung einer Verbindungsstelle des Sensors zur Außenseite, wobei die Öffnung die erste Leitschicht (24), die während der durchgeführten Herstellungsschritte auf der Vorderseite gebildet wurde, punktuell freilegt;
- das Aufbringen einer zweiten Leitschicht (42) auf der Rückseite in Kontakt mit dem Silicium des Substrats in der Öffnung (40) und außerhalb der Öffnung, wobei die zweite Schicht in Kontakt mit der ersten Schicht (24) in der Öffnung kommt;
- die Gravur der zweiten Leitschicht (42), um eine Verbindungsstelle in Kontakt mit dem Silicium außerhalb der Öffnung und in Kontakt mit der ersten Leitschicht (24) in der Öffnung zu begrenzen;
- die Öffnung eines Umfangsgrabens (48) durch die gesamte Stärke des verdünnten Siliciumsubstrats bis zur Isolierschicht (22) gelegen unter diesem verdünnten Substrat, wobei dieser Graben die Verbindungsstelle vollständig umgibt und der Boden des Grabens vollständig aus der Isolierschicht besteht, und somit eine verdünnte Siliciuminsel gebildet wird, die durch die Verbindungsstelle überdeckt und von dem Graben des Rests des verdünnten Siliciumsubstrats, der die aktiven Elemente und besonders die lichtempfindlichen Elemente enthält, isoliert ist.

2. Verfahren nach Anspruch 1, **dadurch gekennzeichnet, dass** ein Draht (60) an einen Abschnitt der Verbindungsstelle geschweißt ist.

3. Verfahren nach Anspruch 2, **dadurch gekennzeichnet, dass** der Abschnitt (46) der Verbindungsstelle an den der Draht geschweißt ist, frei von Punktöffnungen ist.

4. Verfahren nach einem der Ansprüche 1 bis 3, **dadurch gekennzeichnet, dass** eine isolierende Schutzschicht (50) auf die Rückseite nach Öffnung des Grabens aufgebracht wird, und eine Öffnung in diese Schicht graviert wird, um einen Teil der Oberfläche der Verbindungsstelle, an der ein Draht angeschweißt wird, abzulösen.

5. Verfahren nach einem der vorherigen Ansprüche, **dadurch gekennzeichnet, dass** die Punktöffnungen durch chemische Gravur gemacht werden.

6. Verfahren nach einem der vorherigen Ansprüche, **dadurch gekennzeichnet, dass** der Graben durch vertikalen anisotropen Angriff graviert wird.

7. Verfahren nach einem der vorherigen Ansprüche, **dadurch gekennzeichnet, dass** eine Reihe von Punktöffnungen durch das verdünnte Substrat graviert werden, wobei diese Öffnungen über einem leitenden Bereich der ersten Leitschicht (24) verteilt sind, wobei dieser Bereich dazu bestimmt ist, elektrisch mit der Verbindungsstelle verbunden zu werden.

## Claims

1. Method of fabricating an image sensor with thinned silicon substrate, comprising fabrication steps carried out from a front face of a silicon substrate, said steps comprising forming active elements and especially photosensitive elements of the image sensor, the deposition of at least one insulating layer (22) and the deposition of a first conductive layer (24), said insulating layer (22) coating the front face of the silicon substrate and said first conductive layer (24) being embedded in said insulating layer (22), then the transfer of the front face covered with the insulating layer (22) onto a transfer substrate, then the thinning of the silicon substrate on its rear face to a thickness of 3 to 20 micrometers, and finally fabrication steps carried out on the rear face of the thinned silicon substrate that successively comprise:
- etching of at least one localized contact opening (40) through the thinned substrate (12), on a surface area reserved for the creation of an external connection terminal for the sensor, the opening locally exposing said first conductive layer (24) formed during the fabrication steps carried out from the front face;
- depositing a second conductive layer (42) on the rear face, in contact with the silicon in the opening (40) and outside the opening, the second layer coming into contact with the first layer (24) in the opening;
- etching the second conductive layer (42) to delimit a connection terminal in contact with the silicon outside the opening and in contact with the first layer (24) in the opening;
- opening a peripheral trench (48) through the entire thickness of the thinned silicon substrate to the insulating layer (22) located under this thinned substrate, this trench completely surrounding the connection terminal and the bottom of the trench being entirely formed by the insulating layer, so forming an island of thinned silicon covered by the connection terminal and insulated by the trench from the rest of the thinned silicon substrate which contain the active elements and especially the photosensitive elements.

2. Method according to claim 1, wherein a wire is soldered to a part of the connection terminal.

3. Method according to claim 2, wherein the part (46) of the connection terminal to which the wire is soldered has no localized openings.

4. Method according to any of claims 1 to 3, wherein an insulating protective layer (50) is deposited on the rear face after opening the trench, and an opening is etched in this layer to release a portion of surface area of the connection terminal, to which a wire is soldered.

5. Method according to any of the preceding claims, **characterized in that** the localized openings are made by chemical etching.

6. Method according to any of the preceding claims, **characterized in that** the trench is etched by vertical anisotropic attack.

7. Method according to any of the preceding claims, **characterized in that** a series of localized openings is etched through the thinned substrate, these openings being distributed above a conductive land of the first conductive layer (24), this land being intended to be electrically linked to the connection terminal.
